# EUROPÄISCHE PATENTSCHRIFT

(11) **EP 1 843 393 B1**
(45) Veröffentlichungstag und Bekanntmachung des Hinweises auf die Patenterteilung: **13.03.2013**
(21) Anmeldenummer: 07002033.4
(22) Anmeldetag: 31.01.2007
(51) Int. Cl.: H01L 23/48, H01L 25/07

(54) **Leistungshalbleitermodul in Druckkontaktausführung**
Pressure contact type power semiconductor module
Module de puissance semi-conducteur de type à contact par pression

(30) Priorität: 13.02.2006 DE 102006006425
(43) Veröffentlichungstag der Anmeldung: 10.10.2007
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A- 0 138 048
- DE-A1- 4 237 632
- DE-A1- 19 719 703
- DE-A1- 19 903 875
- DE-A1-102004 021 927
- DE-C1- 10 127 947

## Beschreibung

Die Erfindung beschreibt ein Leistungshalbleitermodul in Druckkontaktausführung mit steuerbaren Leistungshalbleiterbauelementen. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Druck kontaktierte Leistungshalbleitermodule, wie sie aus der DE 42 37 632 A1, der DE 199 03 875 A1 oder der DE 101 27 947 C1 bekannt sind. Bei erstgenannter Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgehen.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Die DE 199 03 875 A1 bildet das bekannte Druckelement derart weiter, dass es einerseits ein besonders vorteilhaftes Verhältnis aus Gewicht und Stabilität aufweist und andererseits elektrisch isolierte Durchführungen aufweist. Hierzu ist das Druckelement als ein Kunststoffformkörper mit innen liegender Metallseele ausgebildet. Diese Metallseele weist Ausnehmungen für die Durchführung von Anschlusselementen, vorzugsweise Hilfsanschlusselementen in Federkontaktausführung, auf. Der Kunststoffformkörper umschließt diese Ausnehmungen derart, dass die Hilfsanschlusselemente mittels des Kunststoffformkörpers elektrisch von der Metallseele isoliert sind.

Es sind auch weitergebildete Druckelemente bekannt, die an ihrer dem Substrat zugewandten Oberfläche eine Vielzahl von Druckfingern aufweisen. Vorzugsweise weist hierbei die Metallseele noch eine voreingestellte Durchbiegung auf. In der Kombination beider Maßnahmen kann ein derartiges Druckelement die gesamte Funktionalität einer oben genannten Druckeinrichtung bereitstellen.

Aus der DE 101 27 947 C1 ist ein Leistungshalbleitermodul bekannt, wobei die Lastanschlusselemente derart ausgebildet sind, dass sie in Abschnitten eng benachbart senkrecht zur Substratoberfläche verlaufen und von dort ausgehende Kontaktfüße aufweisen, die den elektrischen Kontakt zu den Leiterbahnen herstellen und gleichzeitig Druck auf das Substrat ausüben und somit dessen thermischen Kontakt zu einem Kühlbauteil herstellen. Der Druck wird hierbei mit Mitteln nach dem Stand der Technik eingeleitet und gespeichert.

Aus der DE 10 2004 021 927 A1 ist ein Verfahren zur inneren Isolation von Leistungshalbleitermodulen bekannt, wobei diese im Gegensatz zum vorbekannten Stand der Technik nicht bis zu einer definierten Füllhöhe mit einem isolierenden Silikongel verfüllt sind. Im Gegensatz dazu wird hier ein Verfahren zur Beschichtung der zu isolierenden Bauteile und Verbindungselemente vorgestellt, welches eine erhebliche Menge an Silikongel einspart.

Der Erfindung liegt die Aufgabe zugrunde ein Leistungshalbleitermodul in Drückkontaktausführung vorzustellen, wobei die innere Isolation verbessert wird, die Ausbildung der Druckkontaktausführung vereinfacht wird und das Leistungshalbleitermodul vorteilhaft für die Anwendung eines Beschichtungsverfahrens zur Isolation des Substrats ausgebildet ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul in Druckkontaktausführung zur Anordnung auf einem Kühlbauteil mit mindestens einem Substrat, mindestens zwei steuerbaren Leistungshalbleiterbauelementen, beispielhaft bipolaren Transistoren, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Das erfindungsgemäße Leistungshalbleitermodul weist weiterhin Lastanschlusselemente jeweils ausgebildet als Metallformkörper mit einem bandartigen Abschnitt und mit einer Mehrzahl von diesem ausgehenden Kontaktfüßen auf. Die jeweiligen bandartige Abschnitte sind parallel zur Substratoberfläche und von dieser beabstandet angeordnet. Die Kontaktfüße, die von dem bandartigen Abschnitt ausgehen, reichen zum Substrat und bilden dort schaltungsgerecht die Kontakte der Lastanschlüsse aus. Vorzugsweise kontaktieren sie hierzu auf dem Substrat die Leiterbahnen mit Lastpotential oder auch direkt die einzelnen Leistungshalbleiterbauelemente.

Weiterhin ist zwischen den bandartigen Abschnitten der Lastanschlusselemente, die hierbei einen Stapel ausbilden, und dem Substrat ein Isolierstoffformkörper angeordnet. Dieser Isolierstoffformkörper weist Ausnehmungen zur Durchführung der Kontaktfüße auf. Der Isolierstoffformkörper bildet hierbei vorzugsweise eine vollständig geschlossene Fläche aus, die ausschließlich Ausnehmungen für elektrische Anschlusselemente aufweist. Es kann weiterhin bevorzugt sein, wenn der lsolierstoffformkörper noch Ausnehmungen für Befestigungseinrichtungen des Leistungshalbleitermoduls auf dem Kühlbauteil aufweist.

Derart ausgebildete Leistungshalbleitermodule in Druckkontaktausführung weisen auf Grund der zusätzlichen isolierenden Zwischenschicht zwischen den bandartigen Abschnitten der Lastanschlusselemente und dem Substrat mit den Leistungshalbleiterbauelementen und den modulinternen Verbindungen eine wesentlich verbesserte innere Isolation auf. Dies gestattet einen verbesserte Ausfallsicherheit im Dauerbetrieb des Leistungshalbleitermoduls.

Durch vorteilhafte, zusätzliche Führungseinrichtungen für die Lastanschlusselemente die einstückig mit dieser Zwischenschicht ausgebildet sind wird gleichzeitig die Ausbildung der Druckkontaktausführung vereinfacht, wobei die Lastanschlusselemente der Druckeinleitung auf das Substrat und damit zu dessen thermischer Anbindung an ein Kühlbauteil dienen. In Kombination mit modernen Beschichtungsverfahren zur inneren Isolation des Substrats ist diese Ausgestaltung des Leistungshalbleitermoduls besonders bevorzugt, da hierbei die gesamte inneren Isolation besonders vorteilhaft und für eine automatisierte Fertigung zugänglich ausgebildet ist.

Die erfinderische Lösung wird an Hand der Ausführungsbeispiele der Fig. 1 bis 3 weiter erläutert.

Fig. 1 zeigt einen Schnitt durch ein erfindungsgemäßes Leistungshalbleitermodul.

Fig. 2 zeigt eine dreidimensionale Explosionszeichnung eines erfindungsgemäßen Leistungshalbleitermoduls.

Fig. 3 zeigt Lastanschlusselemente und Substrate eines erfindungsgemäßen Leistungshalbleitermoduls in dreidimensionaler Darstellung.

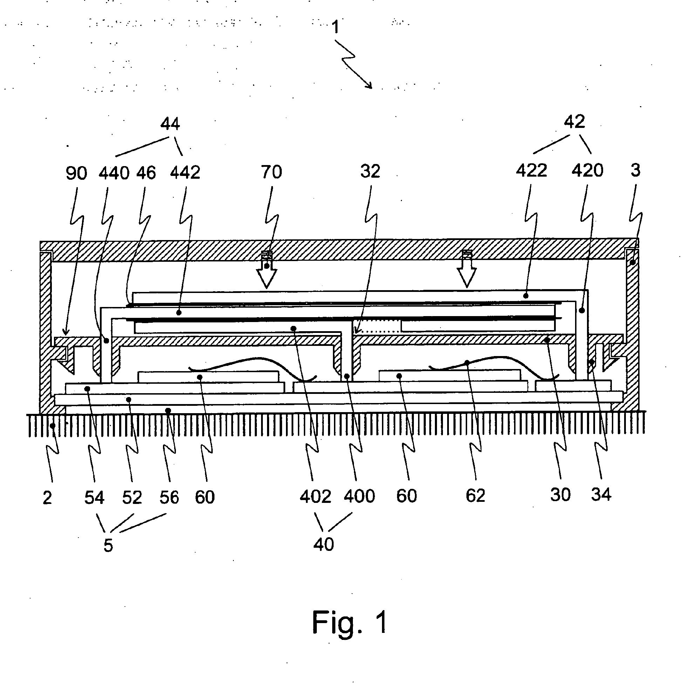

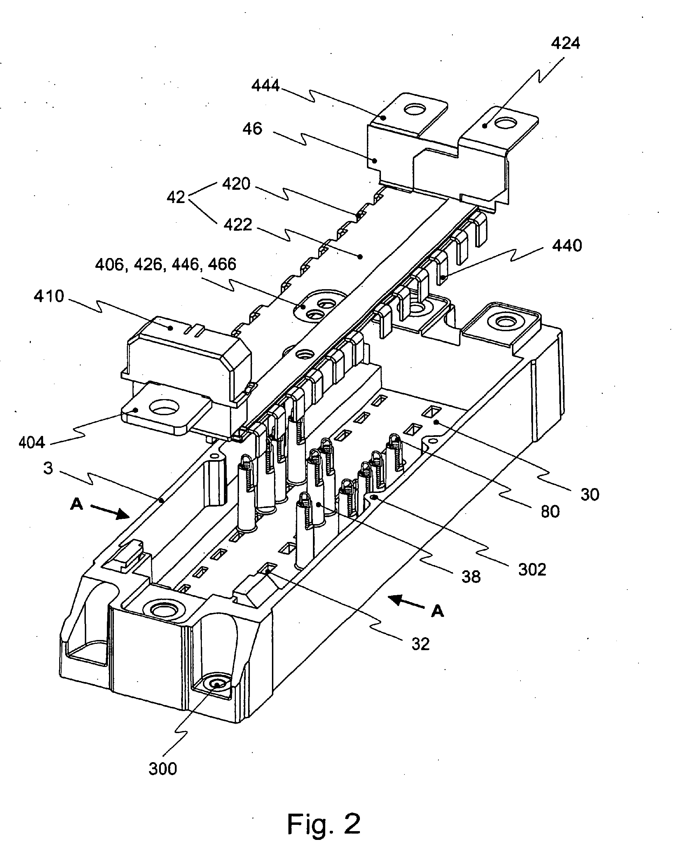

Fig. 1 zeigt einen Schnitt entlang der Linie A-A (vgl. Fig. 2) durch ein erfindungsgemäßes Leistungshalbleitermodul (1). Dieses weist ein Gehäuse (3) mit einem rahmenartigen Gehäuseteil auf. Der rahmenartige Gehäuseteil umschließt hierbei das mindestens eine Substrat (5). Dieses wiederum weist einen Isolierstoffkörper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (56) auf.

Auf den Leiterbahnen (54) des Substrats (5) sind steuerbare und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) mit den verschiedenen notwendigen Potentialen dienen der externen Verbindung der leistungselektronischen Schaltung im Inneren des Leistungshalbleitermoduls (1). Hierzu sind die Lastanschlusselemente (40, 42, 44) als Metallformkörper ausgebildet, die je einen bandartigen Abschnitt (402, 422, 442) parallel zur Substratoberfläche aufweisen. Die bandartigen Abschnitte (402, 422, 442) bilden hierbei einen Stapel, wobei die bandartigen Abschnitte der einzelnen Lastanschlusselemente (40, 42, 44) ausschließlich durch eine notwendige Isolierung (46), beispielhaft in Form einer Kunststofffolie, voneinander beabstandet sind. Notwendige Hilfsanschlusselemente sind aus Gründen der Übersichtlichkeit in dieser Schnittzeichnung nicht dargestellt.

Weiterhin weist das erfindungsgemäße Leistungshalbleitermodul (1) eine als Isolierstoffformkörper (30) ausgebildete Zwischenlage zwischen dem Stapel der bandartigen Abschnitte (402, 422, 442) der Lastanschlusselemente (40, 42, 44) und dem Substrat (5) auf. Dieser Isolierstoffformkörper (30) ist in dieser Ausgestaltung in dem rahmenartigen Gehäuse (3) mittels einer Schnapp- Rast- Verbindung (90) angeordnet.

Der Isolierstoffformkörper (30) weist seinerseits Ausnehmungen (32) zur Durchführung der Kontaktfüße (400, 420, 440) der Lastanschlusselemente (40, 42, 44) auf. Es ist besonders bevorzugt, wenn diese Ausnehmungen (32) als Führungen für diese Kontaktfüße (400, 42, 44) ausgebildet sind, wodurch die Positionierung der Lastanschlusselemente (40, 42, 44) relativ zum Substrat (5) bzw. dessen Leiterbahnen (54) nochmals gegenüber einer Anordnung mit einfachen Ausnehmungen verbessert wird.

Bei einer weiteren besonders bevorzugten Ausgestaltung des Isolierstoffformkörpers sind die Ausnehmungen (32) zur Durchführung der Kontaktfüße als Schächte (34) ausgebildet, wobei diese Schächte (34) bis nahe an die Oberfläche des Substrats (5) heranreichen. Vorteilhafterweise reichen diese Schächte (34) bis in die Isolierstoffschicht beispielhaft ein Silikongel hinein, wobei das Silikongel mittels eines modernen Beschichtungsverfahrens auf das Substrat (5) aufgebracht ist. Hierdurch wird eine besonders wirkungsvolle innere Isolierung des Leistungshalbleitermoduls (1) ausgebildet.

Die Druckeinrichtung (70) zur thermischen Verbindung des Leistungshalbleitermoduls (1) mit einem Kühlbauteil (2) und gleichzeitig zur elektrischen Kontaktierung der Lastanschlusselemente (40, 42, 44) mit den Leiterbahnen (54) des Substrats (5) wird gebildet durch ein Druckelement (72) zum Druckaufbau sowie, ein nicht dargestelltes elastisches Kissenelement zur Druck Speicherung. Der Druck wird über das Kissenelement auf den Stapel aus den bandartigen Abschnitten (402, 422, 442) der Lastanschlusselemente (40, 42, 44) eingeleitet und übt somit Druck auf die Kontaktfüße (400, 420, 440) aus. Hierdurch werden diese elektrisch leitend mit Leiterbahnen (54) des Substrats (5) verbunden.

Derartige Druckkontakierungen (70) haben sich über die Lebensdauer von Leistungshalbleitermodulen (1) als besonders kontaktsicher erwiesen. Weiterhin vorteilhaft für die Druckkontaktierung ist die Ausbildung der Ausnehmungen (32) des Isolierstoffformkörpers (30) als Führungen bzw. Schächte (34), da hierdurch die Positionierung der Kontaktfüße (400, 420, 440) besonders genau ist.

Das Druckelement (72) kann gemäß dem Stand der Technik als Kunststoffformkörper mit geeigneter, beispielhaft als Bimetall ausgebildeter, innen liegender Metallseele ausgeführt sein, wobei hierbei auch auf ein Druck speicherndes Kissenelement verzichtet werden kann. Es ist weiterhin bevorzugt, wenn das Druckelement (72) gleichzeitig als Deckel des Leistungshalbleitermoduls (1) dient.

Fig. 2 zeigt eine dreidimensionale Explosionszeichnung eines Teils des erfindungsgemäßen Leistungshalbleitermoduls (1). Dargestellt ist hierbei ein Kunststoffgehäuse (3) mit Einrichtungen (300) zur Befestigung auf einem Kühlbauteil. Das Gehäuse (3) weist einen einstückig mit diesem ausgebildeten Isolierstoffformkörper (30) auf, der eine Zwischenlage bildet, zwischen dem unterhalb dieser Zwischenlage angeordneten Substrat (5) und den oberhalb dieser Zwischenlage angeordneten bandartigen Abschnitten (402, 422, 442) der Lastanschlusselemente (40, 42, 44).

Weiterhin weist das Gehäuse (3) Befestigungseinrichtungen (302) für ein nicht dargestelltes Druckelement (72) sowie domartige Durchführungen (38) für Hilfsanschlusselemente (80) auf. Es ist besonders bevorzugt in derartigen druckkontaktierten Leistungshalbleitermodulen (1) die Hilfsanschlusselemente als Kontaktfedern (80), vorzugsweise Schraubenfedern, auszubilden.

Die Lastanschlusselemente (40, 42, 44) der verschiedenen Lastpotentiale sind jeweils als Metallformkörper mit Kontakteinrichtung (404, 424, 444) zur externen Verbindung, mindestens einem bandartigen parallel zur Substratoberfläche verlaufenden Abschnitt (402, 422, 442), sowie mit einer Mehrzahl von diesem Abschnitt ausgehenden Kontaktfüßen (400, 420, 440) ausgebildet. Die jeweiligen Lastanschlusselemente (40, 42, 44) sind soweit notwendig mittels eine isolierenden Kunststofffolie (46) voneinander beabstandet und gegeneinander elektrisch isoliert. Das Wechselstromanschlusselement (40) weist weiterhin einen benachbart zur Kontakteinrichtung (404) angeordneten Stromsensor (410) auf.

Die Kontaktfüße (400, 420, 440) der Lastanschlusselemente (40, 42, 44) reichen durch die als Führungen ausgebildeten Ausnehmungen (32) des Isolierstoffformkörpers (30) zu den zugeordneten Kontaktflächen der Leiterbahnen (54) des Substrats (5) bzw. der Leistungshalbleiterbauelemente (60).

Die bandartigen Abschnitte (402, 422, 442) der Lastanschlusselemente (40, 42, 44) sowie deren zugeordnete isolierende Kunststofffolien (46) weisen ihrerseits in denjenigen Bereichen Ausnehmungen (406, 426, 446, 466) auf, in den das Gehäuse (3) Dome (38) für die Hilfsanschlusselemente (80) aufweist. Die zugeordnete, nicht dargestellte Druckeinrichtung (70) ihrerseits weist ebenfalls entsprechende mit den Ausnehmung der Lastanschlusselemente fluchtende Ausnehmung zur Durchführung der Hilfsanschlusselemente auf.

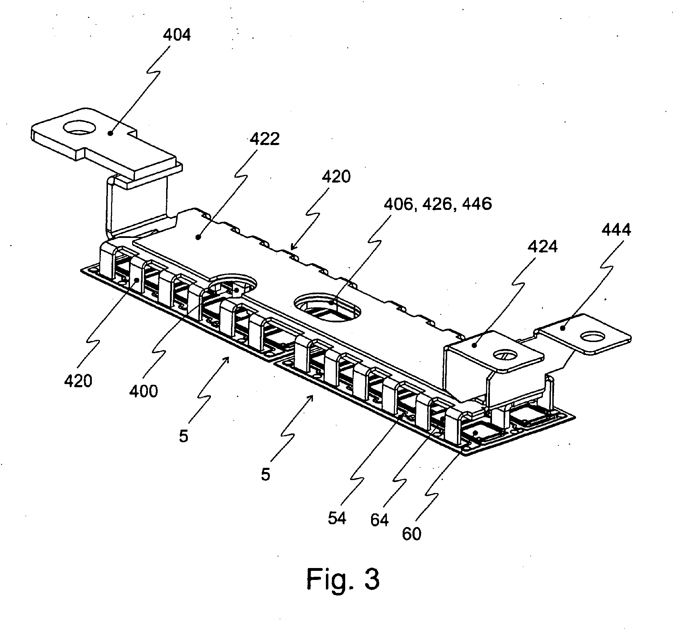

Fig. 3 zeigt Lastanschlusselemente (40, 42, 44) eines erfindungsgemäßen Leistungshalbleitermoduls (1) und deren Position zu zwei Substraten (5) in einer dreidimensionalen Ansicht ohne Darstellung des Gehäuses und der Druckeinrichtung. Aus Gründen der Übersichtlichkeit sind die isolierenden Kunststofffolien zwischen den einzelnen Lastanschlusselementen (40, 42, 44) ebenfalls nicht dargestellt. Die dargestellte Schaltung des Leistungshalbleitermoduls ist eine Halbbrückenschaltung mit einer Mehrzahl die jeweiligen ersten und zweiten Schalter bildenden parallel geschalteten bipolaren Transistoren (60). Ebenfalls weist die Schaltung die notwendigen Freilaufdioden (64) auf. Die ersten und zweiten Schalter der Halbbrückenschaltung sind hierbei jeweils hälftig auf zwei identische Substrate verteilt.

Dargestellt ist die Mehrzahl der Kontaktfüße (400, 420, 440) die von den zugeordneten bandartigen Abschnitten (402, 422, 442) des jeweiligen Lastanschlusselements (40, 42, 44) ausgehen. Jeweils eine Mehrzahl von Kontaktfüßen (400, 420, 440) gleicher Polarität kontaktieren hierbei die zugeordneten Leiterbahnen (54) der jeweiligen Polarität auf beiden Substraten (5). Die dauerhaft kontaktsichere elektrische Verbindung wird mittels der oben beschriebenen Druckeinrichtung ausgebildet.

Dargestellt sind weiterhin Ausnehmung (406, 426, 446) des Stapels aus Lastanschlusselementen (40, 42, 44), die vorgesehen sind für die Anordnung der Hilfsanschlusselemente (80) gemäß Fig. 2.

## Patentansprüche

1. Leistungshalbleitermodul (1) in Druckkontaktausführung, zur Anordnung auf einem Kühlbauteil (2), mit mindestens einem Substrat (5), mindestens zwei hierauf angeordneten Leistungshalbleiterbauelementen (60, 64), einem Gehäuse (3) und nach außen führenden Last- (40, 42, 44) und Hilfsanschlusselementen (80) und mit einer Druckeinrichtung (70), wobei das Substrat (5) einen Isolierstoffkörper (52) aufweist und auf dessen erster dem Inneren des Leistungshalbleitermoduls zugewandten Hauptfläche Leiterbahnen (54) mit Lastpotential angeordnet sind wobei die Lastanschlusselemente (40, 42, 44) jeweils als Metallformkörper mit mindestens einem bandartigen Abschnitt (402, 422, 442) und mit einer Mehrzahl von diesem ausgehenden Kontaktfüßen (400, 420, 440) ausgebildet sind, jeweils ein bandartiger Abschnitt (402, 422, 442) des Lastanschlusselements parallel zur Substratoberfläche und von dieser beabstandet angeordnet ist und die Kontaktfüße (400, 420, 440) von dem bandartigen Abschnitt (402, 422, 442) zum Substrat (5) reichen und dort schaltungsgerecht die Kontakte der Lastanschlüsse ausbilden, und wobei zwischen dem bandartigen Abschnitt (402, 422, 442) der Lastanschlusselemente (40, 42, 44) und dem Substrat (5) ein, vom Substrat selbst beabstandeter, Isolierstoffformkörper (30) angeordnet ist und dieser Ausnehmungen (32) zur Durchführung der Kontaktfüße (400, 420, 440) aufweist.

2. Leistungshalbleitermodul (1) nach Anspruch 1
wobei die Ausnehmungen (32) des Isolierstoffformkörpers (30) zur Durchführung der Kontaktfüße (400, 420, 440) als Führungen hierfür ausgebildet sind und die Kontaktfüße (400, 420, 440) die Leiterbahnen (54) des Substrats (5) kontaktieren.

3. Leistungshalbleitermodul (1) nach Anspruch 1,
wobei der lsolierstoffformkörper (30) und das Gehäuse (3) einstückig ausgebildet sind.

4. Leistungshalbleitermodul (1) nach Anspruch 1
wobei die Ausnehmungen (32) des Isolierstoffformkörpers (30) zur Durchführung der Kontaktfüße als Schächte (34) ausgebildet sind und diese Schächte (34) bis nahe an die Oberfläche des Substrats (5) heran und in eine Isolationsschicht hinein reichen.

5. Leistungshalbleitermodul (1) nach Anspruch 1
wobei die bandartigen Abschnitte (400, 420, 440) der Lastanschlusselemente (40, 42, 44) einen Stapel bilden, hierin gegeneinander elektrisch isoliert sind und wobei die Druckeinrichtung (70) auf diesen Stapel Druck ausübt und somit die Kontaktfüße (400, 420, 440) elektrisch leitend mit Leiterbahnen (54) des Substrats (5) verbunden sind.

6. Leistungshalbleitermodul (1) nach Anspruch 1
wobei die Druckeinrichtung (70), die bandartigen Abschnitte (402, 422, 442) der Lastanschlusselemente (40, 42, 44) und der Isolierstoffformkörper (30) Ausnehmungen (32) zur Durchführung von als Schraubenfedern mit Kontakteinrichtungen ausgebildeten Hilfsanschlusselemente (80) aufweisen.

7. Leistungshalbleitermodul (1) nach Anspruch 6
wobei der Isolierstoffformkörper (30) Dome (38) um die Ausnehmungen zur Durchführung der Hilfsanschlusselemente (80) aufweist.

## Claims

1. A power semiconductor module (1) in a pressure contact embodiment, for purposes of arrangement on a cooling component (2), with at least one substrate (5), at least two power semiconductor components (60, 64) arranged hereon, a housing (3), and load connecting elements (40, 42, 44) and ancillary connecting elements (80) leading outwards, and with a pressure device (70), wherein the substrate (5) has a body of insulating material (52) and on its first prime surface, facing towards the interior of the power semiconductor module, conducting tracks (54) at load potential are arranged, wherein the load connecting elements (40, 42, 44) in each case are designed as metal mouldings with at least one strip-type section (402, 422, 442) and with a number of contact feet (400, 420, 440) emanating from the latter; in each case a strip-type section (402, 422, 442) of the load connecting element is arranged parallel to the substrate surface and spaced apart from the latter, and the contact feet (400, 420, 440) extend from the strip-type section (402, 422, 442) to the substrate (5) and there form the contacts of the load connections in a manner appropriate to the circuit, and wherein between the strip-type section (402, 422, 442) of the load connecting elements (40, 42, 44), and the substrate (5) is arranged an insulating material moulding (30), spaced apart from the substrate itself, and the insulating material moulding has openings (32) for purposes of leading through the contact feet (400, 420, 440).

2. The power semiconductor module (1) in accordance with Claim 1, wherein
the openings (32) of the insulating material moulding (30) for purposes of leading through the contact feet (400, 420, 440) are designed as guides for this purpose, and the contact feet (400, 420, 440) make contact with the conducting tracks (54) of the substrate (5).

3. The power semiconductor module (1) in accordance with Claim 1, wherein
the insulating material moulding (30) and the housing (3) are integrally designed.

4. The power semiconductor module (1) in accordance with Claim 1, wherein
the openings (32) of the insulating material moulding (30) for purposes of leading through the contact feet are designed as shafts (34), and the said shafts (34) extend nearly as far as the surface of the substrate (5), and extend into an insulation layer.

5. The power semiconductor module (1) in accordance with Claim 1, wherein
the strip-type sections (400, 420, 440) of the load connecting elements (40, 42, 44) form a stack, herein are electrically insulated from one another, and wherein the pressure device (70) exerts pressure onto the said stack, and thus the contact feet (400, 420, 440) are connected with the conducting tracks (54) of the substrate (5) in an electrically conducting manner.

6. The power semiconductor module (1) in accordance with Claim 1, wherein
the pressure device (70), the strip-type sections (402, 422, 442) of the load connecting elements (40, 42, 44), and the insulating material moulding (30) have openings (32) for purposes of leading through ancillary connecting elements (80) designed as coil springs with contact devices.

7. The power semiconductor module (1) in accordance with Claim 6, wherein
the said insulating material moulding (30) has spindles (38) around the openings for purposes of leading through the ancillary connecting elements (80).

## Revendications

1. Module semi-conducteur de puissance (1) de type à contact à pression directe, destiné à être disposé sur un élément de refroidissement (2), avec au moins un substrat (5), au moins deux composants semi-conducteurs de puissance (60, 64) disposés sur celui-ci, un boîtier (3) et des éléments de connexion de charge (40, 42, 44) et des éléments de connexion auxiliaires (80) conduisant vers l'extérieur, et avec un dispositif de pression (70), dans lequel le substrat (5) comporte un corps en matériau isolant (52) et des pistes conductrices (54) à potentiel de charge sont disposées sur la première surface principale dudit corps opposée à l'intérieur du module semi-conducteur de puissance, dans lequel les éléments de connexion de charge (40, 42, 44) sont réalisés comme corps moulés métalliques avec chacun au moins un segment en forme de bande (402, 422, 442) et avec une pluralité de plots de contact (400, 420, 440) partant de celui-ci, chaque segment en forme de bande (402, 422, 442) de l'élément de connexion de charge étant disposé parallèlement à la surface de substrat et étant espacé de celle-ci, et les plots de contact (400, 420, 440) s'étendant du segment en forme de bande (402, 422, 442) vers le substrat (5) dans lequel ils forment les contacts des connexions de charge pour réaliser la commutation, et dans lequel un corps moulé en matériau isolant (30) est disposé entre le segment en forme de bande (402, 422, 442) des éléments de connexion de charge (40, 42, 44) et le substrat (5) en étant espacé du substrat en tant que tel, ledit corps présentant des évidements (32) pour le passage des plots de contact (400, 420, 440).

2. Module semi-conducteur de puissance (1) selon la revendication 1,
dans lequel les évidements (32) du corps moulé en matériau isolant (30) pour le passage des plots de contact (400, 420, 440) sont réalisés comme guides correspondants, et les plots de contact (400, 420, 440) contactent les pistes conductrices (54) du substrat (5).

3. Module semi-conducteur de puissance (1) selon la revendication 1,
dans lequel le corps moulé en matériau isolant (30) et le boîtier (3) sont constitués d'une seule pièce.

4. Module semi-conducteur de puissance (1) selon la revendication 1,
dans lequel les évidements (32) du corps moulé en matériau isolant (30) pour le passage des plots de contact sont réalisés sous forme de cheminées (34), et lesdites cheminées (34) se rapprochent de la surface du substrat (5) et pénètrent dans une couche d'isolation.

5. Module semi-conducteur de puissance (1) selon la revendication 1,
dans lequel les segments en forme de bande (400, 420, 440) des éléments de connexion de charge (40, 42, 44) forment une pile où ils sont électriquement isolés entre eux, et dans lequel le dispositif de pression (70) exerce une pression sur ladite pile, et les plots de contact (400, 420, 440) sont ainsi reliés de manière électriquement conductrice aux pistes conductrices (54) du substrat (5).

6. Module semi-conducteur de puissance (1) selon la revendication 1,
dans lequel le dispositif de pression (70), les segments en forme de bande (402, 422, 442) des éléments de connexion de charge (40, 42, 44) et le corps moulé en matériau isolant (30) présentent des évidements (32) pour le passage d'éléments de connexion auxiliaires (80) réalisés sous forme de ressorts hélicoïdaux avec des dispositifs de contact.

7. Module semi-conducteur de puissance (1) selon la revendication 6,
dans lequel le corps moulé en matériau isolant (30) présente des dômes (38) autour des évidements pour le passage des éléments de connexion auxiliaires (80).
